# EUROPÄISCHE PATENTSCHRIFT

(11) **EP 3 332 482 B1**
(45) Veröffentlichungstag und Bekanntmachung des Hinweises auf die Patenterteilung: **03.04.2019**
(21) Anmeldenummer: 16720713.3
(22) Anmeldetag: 23.04.2016
(51) Int. Cl.: H03K 17/96, B60K 37/06

(54) **KRAFTFAHRZEUG-BEDIENVORRICHTUNG MIT ENTKOPPLUNG FÜR KRAFTSENSOR UND HAPTIK-AKTOR SOWIE KRAFTFAHRZEUG**
MOTOR-VEHICLE OPERATING DEVICE HAVING DECOUPLING FOR A FORCE SENSOR AND A HAPTIC ACTUATOR, AND MOTOR VEHICLE
DISPOSITIF DE COMMANDE POUR VÉHICULE AUTOMOBILE À DÉCOUPLAGE POUR CAPTEUR DE FORCE ET AGENT D'ACTION HAPTIQUE ET VÉHICULE AUTOMOBILE

(30) Priorität: 06.08.2015 DE 102015010355
(43) Veröffentlichungstag der Anmeldung: 13.06.2018
(73) Patentinhaber: Audi AG, 85045 Ingolstadt (DE)
(72) Erfinder: WACHINGER, Michael, 86571 Winkelhausen (DE)
(86) Internationale Anmeldenummer: PCT/EP2016/000653
(87) Internationale Veröffentlichungsnummer: WO 2017/020975

(56) Entgegenhaltungen:
- DE-A1-102008 060 256
- US-A1- 2009 314 156
- US-A1- 2014 339 849

## Beschreibung

Die Erfindung betrifft eine Bedienvorrichtung für ein Kraftfahrzeug, welche ein Bedienteil aufweist, das beispielsweise als Tastenleiste oder Touchpad ausgestaltet sein kann. Zum Erfassen einer auf das Bedienteil wirkenden Bedienkraft ist ein Kraftsensor bereitgestellt. Zum Erzeugen einer taktilen oder haptischen Rückmeldung ist eine Aktoreinrichtung bereitgestellt, welche das Bedienteil mit einer Aktorkraft beaufschlagen kann, die der Bedienkraft entgegen wirkt. Zu der Erfindung gehört auch ein Kraftfahrzeug mit der erfindungsgemäßen Bedienvorrichtung.

Bei einer solchen Bedienvorrichtung mit Kraftsensor und Aktoreinrichtung ist es wichtig, dass bei einem Betrieb der Aktoreinrichtung nicht zugleich der Kraftsensor übersteuert und hierdurch unter Umständen beschädigt wird. Denn kann es vorkommen, dass die von der Aktoreinrichtung erzeugte Aktorkraft nicht nur auf das Bedienteil wirkt, sondern auch auf den Kraftsensor übertragen wird, der dann Schaden nehmen kann.

Aus der DE 10 2013 006 414 A1 ist eine Bedienvorrichtung für ein Kraftfahrzeug beschrieben, bei welcher eine Tastenleiste um eine Drehachse drehbar gelagert ist. Durch Beaufschlagen des Bedienteils mit einer Bedienkraft kippt die Tastenleiste nach unten und beaufschlagt hierbei einen Kraftsensor mit der auf eine Bedienoberfläche des Bedienteils wirkenden Bedienkraft. Eine Aktoreinrichtung zum Erzeugen einer haptischen Rückmeldung an der Bedienoberfläche lenkt das Bedienteil dann senkrecht zur Bedienkraft parallel zur Drehachse aus.

Nachteilig bei dieser Ausführungsform ist, dass das Bedienteil drehbar gelagert sein muss, was nicht für alle Anwendungsfälle eine günstige Anordnung ist.

Aus der US 2011/0141052 A1 ist ein Touchpad beschrieben, das mittels einer Aktoreinrichtung in eine Vibrationsbewegung versetzt werden kann. Die Aktoreinrichtung kann hierbei über ein Hebelelement mit dem Touchpad gekoppelt sein, über welches die Aktorkraft übertragen wird. Die Bewegung des Touchpads erfolgt hierbei in einer Ebene der Bedienoberfläche des Touchpads, also wieder senkrecht zur Bedienkraft, die auf das Touchpad wirkt.

Aus der DE 10 2010 026 910 A1 ist eine Bedienvorrichtung für ein Kraftfahrzeug bekannt, bei welcher eine auf eine Bedienoberfläche eines bewegbaren Bedienteils wirkende Bedienkraft über einen Zapfen auf einen Kraftsensor übertragen wird. Um eine Beaufschlagung des Kraftsensors mit der Bedienkraft gezielt zu verhindern, sind Sperrklinken vorgesehen, welche ein Absinken des Bedienteils auf den Kraftsensor bedarfsweise blockieren können. Nachteilig bei dieser Ausführungsform ist, dass zunächst die Sperrklinken eingerastet oder aktiviert werden müssten, um hierdurch den Kraftsensor zu schonen, wenn die Aktoreinrichtung ihre Aktorkraft auf das Bedienteil ausübt.

Der Erfindung liegt die Aufgabe zugrunde, bei einer Bedienvorrichtung eines Kraftfahrzeugs eine Rückwirkung der Aktoreinrichtung auf den Kraftsensor zu vermeiden, wobei das betätigungsabhängige Auslenken des Bedienteils und die aktorbasierte Bewegung des Bedienteils entlang derselben Bewegungslinie erfolgen können sollen.

Die Aufgabe wird durch die Gegenstände der unabhängigen Patentansprüche gelöst. Vorteilhafte Weiterbildungen der Erfindung sind durch die Merkmale der abhängigen Patentansprüche gegeben.

Durch die Erfindung ist eine Bedienvorrichtung für ein Kraftfahrzeug bereitgestellt. Die Bedienvorrichtung weist ein Bedienteil auf, das entlang einer Betätigungsrichtung aus einer Ruhelage auslenkbar gelagert ist. Das Bedienteil kann beispielsweise als Taste oder Tastenleiste oder Touchpad ausgestaltet sein. Ein Kraftsensor ist derart ausgelegt, dass er ein Kraftsignal erzeugt, das mit einer in die Betätigungsrichtung auf eine Bedienoberfläche des Bedienteils wirkenden Bedienkraft korreliert. Je stärker also ein Benutzer beispielsweise mit dem Finger auf die Bedienoberfläche drückt, desto größer ist beispielsweise eine Amplitude des Kraftsignals. Es kann auch vorgesehen sein, dass der Kraftsensor lediglich ein binäres oder zweiwertiges Signal erzeugt, wobei das Kraftsignal hierdurch anzeigt, ob die Bedienkraft betragsmäßig größer oder kleiner als ein vorbestimmter Schwellenwert ist.

Zum Erzeugen eines haptischen oder taktilen Feedbacks (Rückmeldung) an der Bedienoberfläche ist eine Aktoreinrichtung bereitgestellt. Die Aktoreinrichtung ist derart ausgelegt, dass sie in Abhängigkeit von einem Aktivierungssignal das Bedienteil mit einer entgegen der Betätigungsrichtung wirkenden Aktorkraft beaufschlagt. Beispielsweise kann die Aktorkraft eine zeitlichen Verlauf des Betrags aufweisen, der einen Impuls oder ein Wechselsignal oder eine Vibration darstellt. Einen Impuls spürt der Benutzer an der Bedienoberfläche beispielsweise als Klicken oder Schalterschütterung. Der Impuls ist dabei insbesondere kürzer als 500 Millisekunden. Ein Wechselsignal mit beispielsweise sinusförmiger oder sägezahnförmiger oder pulsfolgenförmiger Amplitude spürt der Benutzer an der Bedienoberfläche beispielsweise als Vibration.

Um nun immer dann, wenn die Aktoreinrichtung die Aktorkraft auf das Bedienteil ausübt, den Kraftsensor zu schützen oder zu schonen, ist erfindungsgemäß vorgesehen, dass das Bedienteil und der Kraftsensor und die Aktoreinrichtung miteinander über ein Hebelelement gekoppelt sind, um die beschriebenen Kräfte, das heißt die Bedienkraft und die Aktorkraft, zu übertragen. Mit anderen Worten ist das Bedienteil zum Übertragen der Bedienkraft und der Aktorkraft über ein Hebelelement sowohl mit dem Kraftsensor als auch der Aktoreinrichtung gekoppelt. Das Hebelelement kann beispielsweise als Wippe oder Platte ausgestaltet sein, die um eine Drehachse drehbar gelagert ist. Das Hebelelement kann dazu beispielsweise auf einer Metallstange oder Metallwelle gelagert sein, welche ein Drehlager für das Hebelelement bildet, wodurch dann die beschriebene Drehachse definiert ist. Das Bedienteil ist hierbei einerseits des Hebelelements (also auf einer Seite des Hebelelements), und der Kraftsensor und die Aktoreinrichtung sind andererseits des Hebelelements (also auf der gegenüberliegenden Seite des Hebelelements) angeordnet. Mit anderen Worten ist das Hebelelement zwischen dem Bedienteil einerseits und dem Kraftsensor und der Aktoreinrichtung andererseits angeordnet. Der Kraftsensor und die Aktoreinrichtung wiederum sind auf unterschiedlichen Seiten der Drehachse des Hebelelements angeordnet. Mit anderen Worten verläuft die Drehachse zwischen dem Kraftsensor und der Aktoreinrichtung. Mit anderen Worten ist sie zwischen dem Kraftsensor und der Aktoreinrichtung angeordnet. Durch diese Anordnung wird also das Hebelelement auf der Seite des Kraftsensors von diesem wegbewegt, wenn die Aktoreinrichtung auf ihrer Seite an dem Hebelelement zieht. Der Kraftsensor ist hierbei insbesondere ausschließlich im Bezug auf eine Druckkraft mit dem Hebelelement gekoppelt. Mit anderen Worten liegt das Hebelelement nur an dem Kraftsensor an, ist aber mit diesem nicht beispielsweise durch eine Verklebung auch auf Zug verbunden.

Durch die Erfindung ergibt sich der Vorteil, dass durch Aktivieren der Aktoreinrichtung die auf den Kraftsensor wirkende Bedienkraft verringert werden kann und zugleich die Aktorkraft ausschließlich auf das Bedienteil wirkt und eben nicht auch zusätzlich auf den Kraftsensor. Es ergibt sich also eine Kopplung oder Entlastung des Kraftsensors beim Auslösen oder Aktivieren der Aktoreinrichtung.

Zu der Erfindung gehören auch optionale Weiterbildungen, durch deren Merkmale sich zusätzliche Vorteile ergeben.

Gemäß einer Weiterbildung liegt das Bedienteil nicht direkt an dem Hebelelement an, sondern ein Übertragungselement zum Übertragen der Bedienkraft von dem Bedienteil zu dem Hebelelement ist vorgesehen. Das Übertragungselement ist bezüglich des Hebelelements auf derselben Seite der Drehachse angeordnet wie der Kraftsensor. Durch die Weiterbildung ergibt sich der Vorteil, dass die Bedienkraft als Druckkraft vom Bedienteil über das Hebelelement auf den Kraftsensor übertragen wird. Zugleich kann die Aktoreinrichtung durch Ausüben einer Zugkraft die auf den Kraftsensor wirkende Bedienkraft verringern. Dies schont den Kraftsensor.

Das Bedienteil, die Aktoreinrichtung und der Kraftsensor berühren das Hebelelement jeweils in einem Berührbereich. Hierbei kann die Berührung auch indirekt über das besagte Übertragungselement (im Falle des Bedienteils) oder ein anderes Koppelelement erfolgen. Ein solches Koppelelement kann beispielsweise einen Stab oder einen Zapfen aufweisen. Es ergeben sich dadurch jeweils Berührbereiche des Übertragungselements, des Kraftsensors und der Aktoreinrichtung einerseits mit dem Hebelelement andererseits andererseits. Im Bezug auf das Einstellen der Hebelwege sieht eine Weiterbildung vor, dass von Abständen der jeweiligen Berührbereiche zur Drehachse derjenige Abstand des Berührbereichs des Übertragungselements, das zu dem Bedienteil führt, am größten ist. Mit anderen Worten ist der Hebelweg des Berührbereichs für das Übertragungselement des Bedienteils am größten. Indem ein Hebelelement bereitgestellt ist, sind also verschiedene Hebelverhältnisse möglich, so dass die zwischen Bedienteil einerseits und Aktoreinrichtung und Kraftsensor andererseits übertragenen Kräfte durch entsprechende Hebelwege eingestellt werden können. Hierdurch ergibt sich der Vorteil, dass die Aktoreinrichtung und/oder der Kraftsensor nur einen verhältnismäßig kleinen Hub oder Bewegungsweg bereitstellen müssen und dennoch das Bedienteil einen dazu im Verhältnis größeren Hub oder Bewegungsweg ermöglicht, der vom Benutzer vorteilhafterweise als Bewegung des Bedienteils haptisch und/oder visuell wahrgenommen werden kann.

Um die beschriebene Zugkraft am Hebelelement durch die Aktoreinrichtung zu erzeugen, sieht eine Weiterbildung vor, dass die Aktoreinrichtung eine elektrische Spule aufweist, welche in Abhängigkeit von dem Aktivierungssignal eine Magnetkraft erzeugt. Das Aktivierungssignal kann hierbei beispielsweise ein Spulenstrom sein, der durch die elektrische Spule fließt. Um aus der Magnetkraft die Aktorkraft in dem Bedienteil zu erzeugen, ist in der Spule ein bewegbar gelagertes, ein ferromagnetisches Material aufweisendes und an dem Hebelelement befestigtes Ankerelement bereitgestellt. Das Ankerelement kann beispielsweise als ferromagnetischer Stab, beispielsweise als Eisenstab, ausgestaltet sein. Das ferromagnetische Material ist insbesondere weichmagnetisch (Koerzitivfeldstärke kleiner als 1 kA/m). Zusätzlich oder alternativ dazu kann das Hebelelement selbst ein ferromagnetisches Material aufweisen, also beispielsweise als Eisenplatte ausgestaltet sein oder eine Eisenplatte aufweisen. Bei aktiviertem Elektromagneten wirkt die besagte Magnetkraft der elektrischen Spule auf das jeweilige ferromagnetische Material. Hierdurch wird dann in vorteilhafter Weise das Hebelelement von der Aktoreinrichtung angezogen, so dass einerseits eine Druckkraft auf das Bedienteil ausgeübt wird und zum anderen die auf den Kraftsensor wirkende Bedienkraft kompensiert oder verringert wird. Falls das ferromagnetische Material ein dauermagnetisches Material ist, ergibt sich der zusätzliche Vorteil, dass die Aktor-kraft bidirektional auf das Bedienteil wirken kann, wodurch beispielsweise auch eine Vibration durch abwechselndes Beaufschlagen des Bedienteils mit einer Zugkraft und einer Druckkraft ermöglicht ist.

Gemäß einer Weiterbildung beaufschlagt eine Rückstelleinrichtung das Bedienteil mit einer zu der beschriebenen Ruhelage hin wirkenden Rückstellkraft. Die Rückstelleinrichtung kann hierzu beispielsweise eine Druckfeder sein. Hierdurch ergibt sich der Vorteil, dass bei abgeschalteter oder desaktiviertes Aktoreinrichtung das Bedienteil die Ruhelage einnimmt. Hierdurch ist dann beispielsweise auch ein Klappern des Bedienteils im Kraftfahrzeug vermieden, wenn das Kraftfahrzeug beispielsweise durch eine Fahrt über einen unebenen Fahruntergrund erschüttert oder vibriert wird.

Gemäß einer Weiterbildung wird durch das Hebelelement die Aktorkraft auf das Bedienteil über ein erstes Hebelverhältnis übertragen. Dieses Hebelverhältnis ist durch den Abstand des Berührbereichs der Aktoreinrichtung einerseits und des Berührbereichs des Bedienteils oder des beschriebenen Übertragungselements andererseits definiert. Dieses Hebelverhältnis zwischen Aktoreinrichtung und Bedienteil ist unterschiedlich oder verschieden zu einem Hebelverhältnis, welches durch das Hebelelement die Bedienkraft von dem Bedienteil zu dem Kraftsensor überträgt. Mit anderen Worten bewirkt eine Auslenkung des Bedienteils um einen vorbestimmten Weg, beispielsweise 1 Millimeter, an dem Kraftsensor einen anderen Auslenkungsweg als beim Aktorelement. Hierdurch ergibt sich der Vorteil, dass der Kraftsensor einerseits beispielsweise auf Grundlage eines Bauelements realisiert werden kann, das verhältnismäßig wenig Bewegung benötigt, beispielsweise ein Piezoelement. Dagegen kann die Aktoreinrichtung ein mechanisch bewegtes Teil aufweisen, beispielsweise einen Anker in einem Elektromagneten, der einen größeren Bewegungsweg ausführt.

Gemäß einer Weiterbildung ist eine Steuereinrichtung bereitgestellt, die derart eingerichtet ist, dass sie in Abhängigkeit von dem Kraftsignal das Aktivierungssignal erzeugt. Die Steuereinrichtung kann hierzu beispielsweise einen Mikrocontroller oder eine Mikroprozessor umfassen. Durch die Weiterbildung ist der Vorteil gegeben, dass durch Betätigen des Bedienteils mit einer Bedienkraft, die größer als ein vorbestimmter Schwellenwert ist, dann das Aktivierungssignal für die Aktoreinrichtung erzeugt wird. Hierdurch spürt der Benutzer also immer dann, wenn er das Bedienteil mit einer ausreichend großen Bedienkraft betätigt (Bedienkraft größer als der Schwellenwert) ein taktiles oder haptisches Rückmeldesignal an der Bedienoberfläche des Bedienteils bereitgestellt bekommt. Somit weiß der Benutzer, wann er die Bedienvorrichtung erfolgreich betätigt hat.

Wie bereits ausgeführt, muss das Bedienteil keine einzelne Taste sein. Gemäß einer Weiterbildung ist das Bedienteil als Touchpad oder als Tastenleiste mit mehreren Tasten ausgestaltet. Eine Sensoreinrichtung ist bereitgestellt, die durch ein Sensorsignal eine Berührstelle signalisiert, an welcher der Benutzer die Bedienoberfläche berührt. Im Falle eines Touchpads kann die Sensoreinrichtung beispielsweise eine Sensormatrix sein. Das Sensorsignal kann im Falle eines Touchpads beispielsweise die Koordinaten einer Berührstelle angeben. Im Falle einer Tastenleiste mit mehreren Tasten kann das Sensorsignal signalisieren, welche der Tasten durch den Benutzer berührt wird. Die Sensoren der Sensoreinrichtung können beispielsweise jeweils durch einen kapazitiven Sensor oder einen Drucksensor realisiert sein. Das Sensorsignal unterscheidet insbesondere zwischen mindestens zwei Berührstellen, insbesondere mehr als zwei Berührstellen.

Zu der Erfindung gehört auch ein Kraftfahrzeug, welches zumindest ein Gerät aufweist. Bei dem zumindest einen Gerät handelt es sich jeweils beispielsweise um ein Infotainmentsystem (Informations-Unterhaltungssystem), eine Klimaanlage, eine Telefonanlage oder eine Fahrwerksteuerung. Des Weiteren weist das erfindungsgemäße Kraftfahrzeug eine Ausführungsform der erfindungsgemäßen Bedienvorrichtung auf, die mit dem zumindest einen Gerät gekoppelt ist und dazu ausgelegt ist, ein Steuersignal an das zumindest eine Gerät in Abhängigkeit von dem Kraftsignal des Kraftsensors zu erzeugen und an das zumindest eine Gerät auszusenden. Durch das Steuersignal wird dann in dem zumindest einen Gerät eine Funktion aktiviert. Bei dem erfindungsgemäße Kraftfahrzeug erfolgt dabei die Erzeugung des Steuersignals immer dann, wenn der Benutzer das Bedienteil der Bedienvorrichtung mit einer ausreichend großen Bedienkraft betätigt, wenn also die Bedienkraft größer als ein vorbestimmter Schwellenwert ist. Es handelt sich bei der Bedienkraft dabei um die beschriebene Bedienkraft, die auf die Bedienoberfläche wirkt und hierdurch das Bedienelement entlang der Betätigungsrichtung aus der Ruhelage auslenkt. Durch die Erfindung ergibt sich der Vorteil, dass in dem Kraftfahrzeug beispielsweise ein Touchpad oder eine Tastenleiste bereitgestellt werden kann, die ein Benutzer an einer Bedienoberfläche betätigt und dann ein taktiles oder haptisches Feedback an der Bedienoberfläche erhält, welches ihm signalisiert, dass er die Bedienvorrichtung erfolgreich betätigt hat, also das Steuersignal erfolgreich an das zumindest eine Gerät ausgesendet worden ist.

Das erfindungsgemäße Kraftfahrzeug ist bevorzugt als Kraftwagen, insbesondere als Personenkraftwagen, ausgestaltet.

Im Folgenden ist ein Ausführungsbeispiel der Erfindung beschrieben. Hierzu zeigt:
- Fig. 1: eine schematische Darstellung einer Ausführungsform des erfindungsgemäßen Kraftfahrzeugs mit einer Bedienvorrichtung, die als Aktoreinrichtung einen Elektromagneten mit bewegbarem Anker aufweist, und
- Fig. 2: das Kraftfahrzeug von Fig. 1, wobei die Bedienvorrichtung alternativ zu Fig. 1 einen Elektromagneten ohne beweglichen Anker aufweist.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

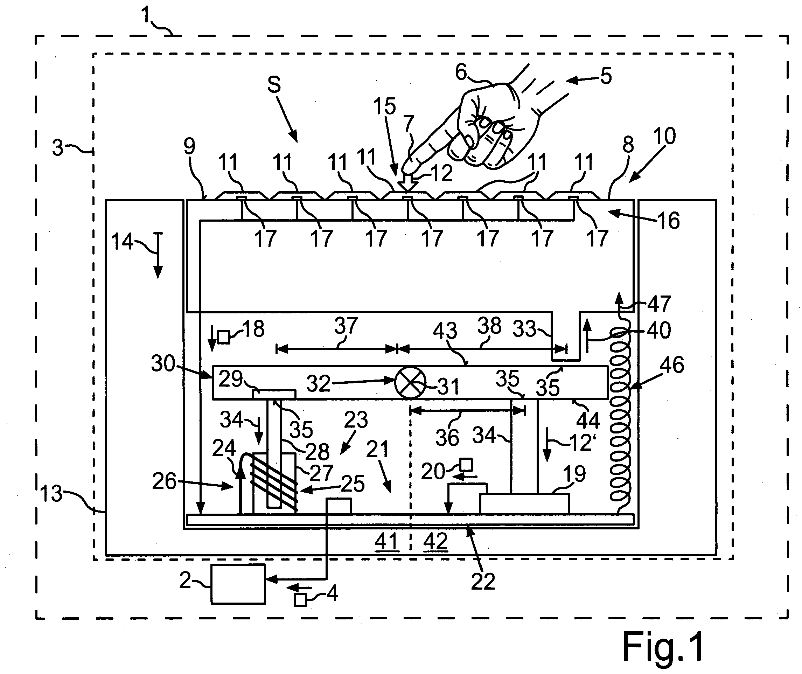

Fig. 1 zeigt ein Kraftfahrzeug 1, bei dem es sich beispielsweise um einen Kraftwagen, insbesondere einen Personenkraftwagen, handeln kann. Dargestellt sind ein Gerät 2 und eine Bedienvorrichtung 3 für das Gerät 2. Die Bedienvorrichtung 3 ist mit dem Gerät 2 gekoppelt, beispielsweise über einen CAN-Bus (CAN - Controller Area Network). Das Gerät 2 kann beispielsweise ein Infotainmentsystem, eine Klimaanlage, eine Telefonanlage oder eine Fahrwerksteuerung sein. Die Bedienvorrichtung 3 kann auch mit mehreren Geräten gekoppelt sein. Die Bedienvorrichtung 3 erzeugt zum Steuern des Geräts 2 ein Steuersignal 4 in Abhängigkeit von einer Betätigung der Bedienvorrichtung 3 durch einen Benutzer 5. Von dem Benutzer ist in der Figur nur eine Hand 6 mit einem Finger 7 dargestellt.

Zum Betätigen der Bedienvorrichtung 3 weist diese ein Bedienteil 8 auf, an dessen Bedienoberfläche 9 in dem gezeigten Beispiel beispielhaft eine Tastenleiste 10 mit mehreren Tasten 11 ausgestaltet sein kann. Der Benutzer 5 betätigt eine der Bedientasten 11, indem er mit dem Finger 7 die Bedienoberfläche 9 im Bereich der Taste 11 mit einer Bedienkraft 12 niederdrückt oder beaufschlagt. Das Bedienteil 8 ist beispielsweise bezüglich eines Gehäuses 13 der Bedienvorrichtung 3 bewegbar entlang einer Betätigungsrichtung 14 gelagert. Die Betätigungsrichtung 14 ist beispielsweise senkrecht zur Bedienoberfläche 9 ausgerichtet, so dass die Bedienkraft 12 parallel oder zumindest teilweise parallel zur Betätigungsrichtung 14 wirkt und hierdurch das Bedienteil 8 in die Betätigungsrichtung 14 aus einer Ruhelage S (in Fig. 1 dargestellt) ausgelenkt wird. Falls die Bedienkraft 12 betragsmäßig größer als ein vorbestimmter Schwellenwert ist, wird durch die Bedienvorrichtung 3 das Steuersignal 4 erzeugt. Hierbei erfolgt die Erzeugung des Steuersignals 4 in Abhängigkeit von der Berührstelle 15, also beispielsweise der berührten Taste 11. In Abhängigkeit von der berührten Taste 11 wird also bei der Bedienkraft 12 größer als der Schwellenwert das Steuersignal 4 erzeugt und an das Gerät 2 ausgesendet, so dass in dem Gerät 2 abhängig von dem Steuersignal 4 eine Gerätefunktion aktiviert oder ausgelöst wird.

In der Bedienvorrichtung 3 erfasst eine Sensorvorrichtung 16, welche Berührstelle 15 berührt worden ist, also beispielsweise welche Taste 11 berührt worden ist. Die Sensoreinrichtung 16 kann hierzu beispielsweise Sensoren 17 aufweisen, von denen jeder beispielsweise als kapazitiver Sensor ausgestaltet sein kann. In Fig. 1 sind der Übersichtlichkeit halber nur einige der Sensoren mit einem Bezugszeichen versehen. Die Berührstelle 15, also beispielsweise die berührte Taste 11, wird durch ein Sensorsignal 18 der Sensoreinrichtung 16 signalisiert.

Der Betrag der Bedienkraft 12 wird durch einen Kraftsensor 19 erfasst. Der Kraftsensor 19 erzeugt ein Kraftsignal 20, welches mit dem Betrag der Bedienkraft 12 korreliert. Die Korrelation ist mindestens in der Weise vorgegeben, dass durch das Kraftsignal 20 unterschieden ist, ob der Betrag der Bedienkraft 12 kleiner oder größer als der Schwellenwert ist. Als Kraftsensor 19 kann beispielsweise ein kraftabhängiger veränderlicher elektrischer Widerstand bereitgestellt sein oder beispielsweise eine Tellerfeder, die bei einem Betrag der Bedienkraft 12 größer als der Schwellenwert eingedrückt wird oder nachgibt und hierdurch beispielsweise elektrische Kontakte kurzschließt oder elektrisch verbindet.

Das Steuersignal 4 wird in Abhängigkeit von dem Sensorsignal 18 und dem Kraftsignal 20 in der beschriebenen Weise erzeugt. Hierzu ist eine Steuereinrichtung 21 bereitgestellt, die beispielsweise auf der Grundlage einer Leiterplatte 22 realisiert sein kann, durch welche eine elektronische Schaltung realisiert sein kann. Die Leiterplatte 22 kann des Weiteren einen Mikrocontroller oder einen Mikroprozessor aufweisen, durch welchen eine Schaltlogik zum Erzeugen des Steuersignals 4 realisiert sein kann. Die Steuereinrichtung 21 empfängt das Sensorsignal 18 und das Kraftsignal 20.

Mit Erzeugen des Steuersignals 4 wird an der Bedienoberfläche 9 des Bedienteils 8 für den Benutzers 5 ein haptisches Rückmeldesignal oder ein taktiles Rückmeldesignal erzeugt. Beispielsweise kann das Bedienteil 8 vibrieren oder eine Stoßbewegung entgegen der Betätigungsrichtung 14 ausführen. Zum Erzeugen des taktilen Rückmeldesignals ist eine Aktoreinrichtung 23 bereitgestellt, die durch die Steuereinrichtung 21 bei Erzeugen des Steuersignals 4 mit einem Spulenstrom 24 beaufschlagt wird. Der Spulenstrom 24 stellt ein Aktivierungssignal im Sinne der Erfindung dar. Beispielsweise kann die Aktoreinrichtung 23 einen Elektromagneten 25 mit einer elektrischen Spule 26 aufweisen. Der Spulenstrom 24 kann dann durch die Spule 26 fließen. Optional kann der Elektromagnet 25 auch einen Eisenkern 27 zur Verstärkung eines durch den Spulenstrom 24 in der Spule 26 erzeugten Magnetfelds aufweisen. In Fig. 1 ist eine Ausführungsform dargestellt, in welcher der Elektromagnet 25 auch einen in der Spule 26 bewegbar gelagerten Anker 28 aufweist, der beispielsweise durch eine Eisenstange realisiert sein kann. An dem Anker 28 kann des Weiteren eine Platte oder ein Stempel 29 für eine Kraftübertragung bereitgestellt sein.

Der Kraftsensor 19 und die Aktoreinrichtung 23 sind mit dem Bedienteil 8 über ein Hebelelement 30 gekoppelt. Das Hebelelement 30 kann beispielsweise als Stab oder Platte ausgestaltet sein. Das Hebelelement 30 ist um eine Rotationsachse oder Drehachse 31 drehbar gelagert. Eine Ausrichtung oder Verlaufsrichtung der Drehachse 31 ist in Fig. 1 senkrecht zur Zeichenebene der Fig. 1 ausgerichtet. Die Drehachse 31 kann beispielsweise durch ein Achselement 32 realisiert sein, bei dem es sich beispielsweise um eine Stange oder eine Welle handeln kann, die (in Fig. 1 nicht gezeigt) drehbar in dem Gehäuse 9 gelagert sein.

Zur Kraftübertragung zwischen dem Hebelelement 30 und dem Bedienteil 8 kann ein Übertragungselement 33 vorgesehen sein, das beispielsweise als Zapfen oder Stutzen an dem Bedienteil 8 ausgebildet sein kann. Das Bedienteil 8 kann beispielsweise ein Spritzgussteil aus Kunststoff sein, an welches das Übertragungselement 33 angeformt ist. Zum Übertragen der Bedienkraft 12 auf den Kraftsensor 19 kann ein weiteres Übertragungselement 34 an den Kraftsensoren 19 oder an dem Hebel 30 angeordnet sein. Das Übertragungselemente 33, 34 und der Anker 28 liegen an dem Hebelelement 30 jeweils an einem Berührbereich 35 an. Abstände 36, 37, 38 des jeweiligen Berührbereichs 35 von der Drehachse 31 können sich unterscheiden. Die Zuordnung der Bezugszeichen 36, 37, 38 zu den jeweiligen Abständen kann der Fig. 1 entnommen werden. Der größte Abstand ist bevorzugt der Abstand 38 des Berührbereichs 35 des Übertragungselement 33 des Bedienteils 8 von der Drehachse 31. Die Abstände können jeweils beispielsweise von einer Mitte des Berührbereichs 35 zu der Drehachse 31 definiert sein.

Durch Beaufschlagen des Bedienteils 8 an der Berühroberfläche 9 mit der Bedienkraft 12 wird diese über das Übertragungselement 33 in einem Verhältnis, das durch die Abstände 38, 36 definiert ist, als übertragene Bedienkraft 12' auf den Kraftsensor 19 übertragen. Der Kraftsensor 19 signalisiert durch das Kraftsignal 20 die Bedienkraft 12. Die Steuereinrichtung 21 erzeugt dann in der beschriebenen Weise das Steuersignal, falls der Betrag der Bedienkraft 12 größer als der Schwellenwert ist. Des Weiteren wird ermittelt, welche Taste 11 der Benutzer 5 hierbei drückt. Dies wird durch das Sensorsignal 18 signalisiert und von der Steuereinrichtung 21 beim Erzeugen des Steuersignals 4 berücksichtigt. Mit der Erzeugen des Steuersignals 4 wird das Aktivierungssignal in Form des Spulenstroms 24 erzeugt, so dass die Aktoreinrichtung 23 eine Zugkraft 39 mittels des Ankers 28 auf das Hebelelement 30 ausübt. Diese Zugkraft 39 wird als Aktorkraft 40 auf das Bedienteil 8 übertragen. Die Aktorkraft 40 wirkt dabei der Auslenkung entlang der Betätigungsrichtung 14 entgegen. Mit anderen Worten sind die Aktorkraft 40 und die Betätigungsrichtung 14 antiparallel ausgerichtet. Der Benutzer spürt mit dem Finger 7 die Aktorkraft 40. Dies kann beispielsweise als Vibration empfunden werden oder als Stoß als Klicken. Ein Verhältnis der Zugkraft 39 zur Aktorkraft 40 ist durch das Verhältnis der Abstände 37, 38 festgelegt. Indem die Aktoreinrichtung 23 und der Kraftsensor 19 an zwei gegenüberliegenden Seiten 41, 42 der Drehachse 31 angeordnet sind, wird durch die Zugkraft 39 auch die übertragene Bedienkraft 12' am Kraftsensor 19 verringert. Mit anderen Worten wird der Kraftsensor 19 nicht durch eine zusätzliche Druckkraft aufgrund der Aktivierung der Aktoreinrichtung 23 beaufschlagt.

Indem das Bedienteil 8 auf einer Seite 43 und die Aktoreinrichtung 23 und der Kraftsensor 19 auf einer gegenüberliegenden zweiten Seite 44 angeordnet sind, können auch die Aktoreinrichtung 23 und der Kraftsensor 19 auf einer gemeinsamen Leiterplatte 22 angeordnet sein.

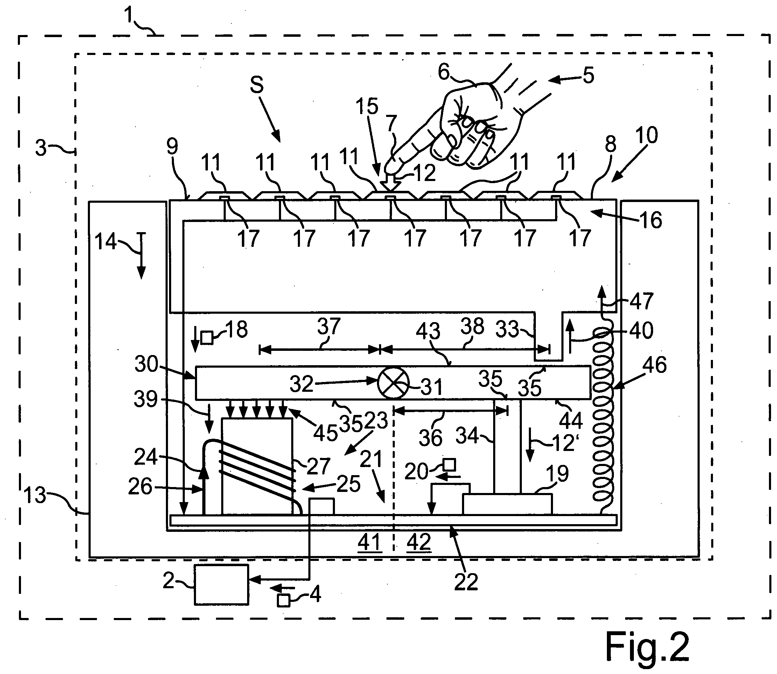

Fig. 2 zeigt die Bedienvorrichtung 3 in einer alternativen Ausführungsform, die ohne ein bewegbar gelagertes Ankerelement 28 auskommt. Die übrige Bauweise der Bedienvorrichtung 3 kann in derselben Weise wie in Fig. 1 vorgesehen sein.

Das in Fig. 1 dargestellte Hebelelement 30 kann beispielsweise als Kunststoffteil ausgestaltet sein. In Fig. 2 ist ein Hebelelement 30 dargestellt, das beispielsweise einen Teilbereich aus ferromagnetischem Material, beispielsweise Eisen, aufweisen kann oder ganz aus dem ferromagnetischen Material gebildet sein kann, beispielsweise als Eisenstab oder Eisenplatte. Dann kann das durch die Spule 26 bei Beaufschlagung mit dem Spulenstrom 24 erzeuge Magnetfeld 45 die Zugkraft 39 direkt auf das Hebelelement 30 ausüben. Auch hier kann optional wieder ein Eisenkern 27 zur Verstärkung des Magnetfelds 45 bereitgestellt sein. Der Eisenkern 27 ist dabei in der Spule 24 angeordnet. Alternativ dazu kann vorgesehen sein, dass die Spule 24 auf der Grundlage von Leiterbahnen der Leiterplatte 22 als Flachspule realisiert ist, indem die Windungen oder Wicklungen der Spule 24 (nicht dargestellt) als Spirale auf der Leiterplatte 22 ausgestaltet sind.

Durch die beiden Beispiele ist gezeigt, wie eine Sensor- und Aktorsteuerung bei einem Bedienelement mit aktiver Haptik über einen Hebel in Form eines Hebelelements 30 realisiert sein kann.

Zentrales Element ist das Hebelelement 30 in der Bedienvorrichtung 3. An der einen Seite 43 des Hebelelements 30 liegt das Bedienteil 8 mit der Bedienoberfläche 9 an. Demgegenüber sitzt der Kraftsensor 19 zur Auswertung der Betätigungskraft 12, der wiederum vorteilhaft auf einer Leiterplatte 22 angeordnet sein. Die Leiterplatte 22 ist auch mit der Steuereinrichtung 21 versehen, die eine Auswerte- und Ansteuereinheit darstellt. Auf der anderen Seite 41 der Drehachse 31 des Hebelelements 30 befindet sich die Aktoreinrichtung 23. Diese kann entweder als Elektromagnet 25 mit Anker 28 (Fig. 1) oder als reine Spule 24 (Fig. 2) ausgeführt sein. Bei einer reinen Spulen-Ausführung ist es von Vorteil, wenn das Hebelelement 30 aus einem ferromagnetischen Werkstoff besteht, da hier das Hebelelement 30 als Anker-Ersatz dienen kann, was zu einer Kostenreduzierung führt. Wird nun auf die Bedienoberfläche 9 eine Bedienkraft 12 ausgeübt, wird diese Bedienkraft 12 direkt auf den Kraftsensor 19 als übertragene Kraft 12' übertragen. Bei einer bestimmten Schwelle, wenn also die Bedienkraft 12 einen Schwellenwert überschreitet, wird die Aktoreinrichtung 23 angesteuert, indem die Spule 26 mit dem Spulenstrom 24 beaufschlagt wird. Die Aktoreinrichtung 23 wirkt dann auf der Hebelseite 41 und wirkt somit dann entgegen der Betätigungsrichtung 14. Hierdurch kann ein mechanischer Impuls oder Kraftimpuls an der Bedienoberfläche 9 als haptischer Impuls wahrnehmbar gemacht werden.

Bei unbestromter Spule 26 wird das Bedienteil durch eine Rückstelleinrichtung 46 in der Ruhelage S gehalten, in dem die Rückstelleinrichtung 46 eine Rückstellkraft 47 auf das Bedienteil ausübt. Die Rückstelleinrichtung 46 kann hierzu beispielsweise eine Feder aufweisen.

Insgesamt zeigt das Beispiel, wie durch die Erfindung ein Kraftsensor und eine Aktoreinrichtung bei einem Bedienelement mit aktiver Haptik über einen Hebel bereitgestellt werden können.

## Patentansprüche

1. Bedienvorrichtung (3) für ein Kraftfahrzeug (1), aufweisend:
- ein Bedienteil (8), das entlang einer Betätigungsrichtung (14) aus einer Ruhelage (S) auslenkbar gelagert ist, wobei das Bedienteil (8) als Touchpad oder als Tastenleiste (10) mit mehreren Tasten (11) ausgestaltet ist und eine Sensoreinrichtung (16) bereitgestellt ist, die durch ein Sensorsignal (18) eine Berührstelle (15), an welcher ein Benutzer (5) eine Bedienoberfläche (9) berührt, signalisiert, wobei die Betätigungsrichtung (14) senkrecht zur Bedienoberfläche (9) ausgerichtet ist, und
- einen Kraftsensor (19), der ein Kraftsignal (20) erzeugt, das mit einer in die Betätigungsrichtung (14) auf die Bedienoberfläche (9) des Bedienteils (8) wirkenden und das Bedienteil (8) aus seiner Ruhelage (S) in die Betätigungsrichtung (14) auslenkenden Bedienkraft (12) korreliert, **gekennzeichnet, durch**
- eine Aktoreinrichtung (23), welche in Abhängigkeit von einem Aktivierungssignal (24) das Bedienteil (8) mit einer entgegen der Betätigungsrichtung (12) wirkenden Aktorkraft (40) beaufschlagt, wobei
das Bedienteil (8) zum Übertragen der Bedienkraft (12) und der Aktorkraft (40) über ein Hebelelement (30) sowohl mit dem Kraftsensor (19) als auch der Aktoreinrichtung (23) gekoppelt ist und hierbei das Bedienteil (8) auf einer Seite (43) des Hebelelements (30) und der Kraftsensor (19) und die Aktoreinrichtung (23) auf einer gegenüberliegenden Seite (44) des Hebelelements (30) angeordnet sind, sodass das Hebelelement (30) zwischen dem Bedienteil (8) einerseits und dem Kraftsensor (19) und der Aktoreinrichtung (23) andererseits angeordnet ist, und der Kraftsensor (19) und die Aktoreinrichtung (23) auf unterschiedlichen Seiten (41, 42) einer Drehachse (31) des Hebelelements (30) angeordnet sind, und wobei ein Übertragungselement (33) zum Übertragen der Bedienkraft (12) von dem Bedienteil (8) zu dem Hebelelement (30) bezüglich des Hebelelements (30) auf derselben Seite (42) der Drehachse (31) wie der Kraftsensor (19) angeordnet ist und das Übertragungselement (33) die Bedienkraft (12) als Druckkraft vom Bedienteil (8) über das Hebelelement (30) auf den Kraftsensor (19) überträgt und die Aktoreinrichtung (23) durch Ausüben einer Zugkraft die auf den Kraftsensor (19) wirkende Bedienkraft (12) verringert.

2. Bedienvorrichtung (3) nach Anspruch 1, wobei von jeweiligen Abständen (36, 37, 38) von jeweiligen Berührbereichen (35) des Übertragungselements (33), des Kraftsensors (19) und der Aktoreinrichtung (23) einerseits mit dem Hebelelement (30) andererseits zur Drehachse (31), der Abstand (38) des Berührbereichs (35) des Übertragungselements (33) am größten ist.

3. Bedienvorrichtung (3) nach einem der vorhergehenden Ansprüche, wobei die Aktoreinrichtung (23) eine elektrische Spule (24) aufweist, welche in Abhängigkeit von dem Aktivierungssignal (24) eine Magnetkraft (45) erzeugt, wobei a) in der Spule (26) eine bewegbar gelagertes, ein ferromagnetisches Material aufweisendes und mit dem Hebelelement (30) gekoppeltes Ankerelement (28) aufweist und/oder b) das Hebelelement (30) ein ferromagnetisches Material aufweist, wobei bei aktiviertem Elektromagneten (25) die Magnetkraft (45) der elektrischen Spule (26) auf das jeweilige ferromagnetische Material wirkt.

4. Bedienvorrichtung (3) nach einem der vorhergehenden Ansprüche, wobei eine Rückstelleinrichtung (46) derart eingerichtet ist, dass sie das Bedienteil (8) mit einer zur Ruhelage (S) hin wirkenden Rückstellkraft (47) beaufschlagt.

5. Bedienvorrichtung (3) nach einem der vorhergehenden Ansprüche, wobei durch das Hebelelement (30) die Aktorkraft (40) auf das Bedienteil (8) über ein erstes Hebelverhältnis übertragen wird, welches unterschiedlich ist zu einem Hebelverhältnis, über welches durch das Hebelelement (30) die Bedienkraft (12) von dem Bedienteil (12) zu dem Kraftsensor (19) übertragen wird.

6. Bedienvorrichtung (3) nach einem der vorhergehenden Ansprüche, wobei eine Steuereinrichtung (21) bereitgestellt und derart eingerichtet ist, dass sie in Abhängigkeit von dem Kraftsignal (20) das Aktivierungssignal (24) erzeugt.

7. Kraftfahrzeug (1) mit zumindest einem Gerät (2) und mit einer Bedienvorrichtung (3) nach einem der vorhergehenden Ansprüche, wobei die Bedienvorrichtung (3) mit dem zumindest einen Gerät (2) gekoppelt ist und dazu ausgelegt ist, in Abhängigkeit von einem Kraftsignal (20) eines Kraftsensors (19) der Bedienvorrichtung (3) ein Steuersignal (4) zu erzeugen und an das zumindest eine Gerät (2) auszusenden.

## Claims

1. Operating device (3) for a motor vehicle (1), comprising:
- an operating part (8) which can be deflected in an actuation direction (14) from a rest position (S), wherein the operating part (8) is configured as a touchpad or as a keypad bar (10) with a plurality of keys (11) and a sensor device (16) is provided which signals a touch point (15) on which a user (5) touches a user interface (9) via a sensor signal (18), wherein the actuation direction (14) is oriented perpendicular to the user interface (9), and
- a force sensor (19) which produces a force signal (20) which is correlated with an operating force (12) acting in the actuation direction (14) on the user interface (9) of the operating part (8) and deflecting the operating part (8) from its rest position (S) in the actuation direction (14),
**characterised by**
- an actuator device (23) which in response to an activation signal (24) applies an actuator force (40) acting counter to the actuation direction (12) to the operating part (8), wherein for transferring the operating force (12) and the actuator force (40) via a lever element (30), the operating part (8) is coupled to both the force sensor (19) and the actuator device (23) and in this way the operating part (8) is arranged on one side (43) of the lever element (30) and the force sensor (19) and the actuator device (23) are arranged on an opposite side (44) of the lever element (30) so that the lever element (30) is arranged between the operating part (8) on the one side and the force sensor (19) and the actuator device (23) on the other, and the force sensor (19) and the actuator device (23) are arranged on different sides (41, 42) of a pivot axis (31) of the lever element (30), and wherein a transfer element (33) for transferring the operating force (12) from the operating part (8) to the lever element (30) relating to the lever element (30) is arranged on the same side (42) of the pivot axis (31) as the force sensor (19), and the transfer element (33) transfers the operating force (12) from the operating part (8) to the force sensor (19) via the lever element (30) as pressure force and the actuator device (23) reduces the operating force (12) acting on the force sensor (19) by exerting a tensile force.

2. Operating device (3) according to claim 1, wherein the distance (38) of the contact region (35) of the transfer element (33) is the greatest of the respective distances (36, 37, 37) of the respective contact regions (35) of the transfer element (33), the force sensor (19) and the actuator device (23) on the one side with the lever element (30) on the other side to the pivot axis (31).

3. Operating device (3) according to any one of the preceding claims, wherein the actuator device (23) has an electrical coil (24) which in response to an activation signal (24) produces a magnetic force (45), wherein a) the coil (26) there is a movably mounted anchor element (28) having a ferromagnetic material and coupled to the level element (30) and/or b) the lever element (30) has a ferromagnetic material, wherein with activated electromagnets (25), the magnetic force (45) of the electrical coil (26) acts on the respective ferromagnetic material.

4. Operating device (3) according to any one of the preceding claims, wherein a restoring device (46) is arranged such that it acts on the operating part (8) with a restoring force (47) acting towards the rest position (S).

5. Operating device (3) according to any one of the preceding claims, wherein the actuator force (40) is transferred to the operating part (8) by the lever element (30) via a first lever ratio which is different to a lever ratio by means of which the operating force (12) is transferred from the operating part (12) to the force sensor (9) by the lever element (30).

6. Operating device (3) according to any one of the preceding claims, wherein a control unit (21) is provided and is arranged such that in response to the force signal (20) the activation signal (24) is produced.

7. Motor vehicle (1) having at least one apparatus (2) and an operating device (3) according to any one of the preceding claims, wherein the operating device (3) is coupled to the at least one apparatus (2) and is designed such that in response to a force signal (20) of a force sensor (19) of the operating device (3), a control signal (4) is produced and sent to the at least one apparatus (2).

## Revendications

1. Dispositif de fonctionnement (3) pour un véhicule automobile (1), présentant :
- une partie de fonctionnement (8), qui est montée de manière à pouvoir être déviée hors d'une position de repos (S) le long d'une direction d'actionnement (14), dans lequel la partie de fonctionnement (8) est configurée sous la forme d'un pavé tactile ou sous la forme d'une barre de boutons (10) avec plusieurs boutons (11) et un système de capteur (16) est fourni, qui signale par un signal de capteur (18) un emplacement de contact (15), au niveau duquel un utilisateur (5) touche une surface de fonctionnement (9), dans lequel la direction d'actionnement (14) est orientée de manière perpendiculaire à la surface de fonctionnement (9), et
- un capteur de force (19), qui génère un signal de force (20), qui est en corrélation avec une force de fonctionnement (12) agissant dans la direction d'actionnement (14) sur la surface de fonctionnement (9) de la partie de fonctionnement (8) et déviant la partie de fonctionnement (8) hors de sa position de repos (S) dans la direction d'actionnement (14),
**caractérisé par**
- un système actionneur (23), qui soumet, en fonction d'un signal d'activation (24), la partie de fonctionnement (8) à l'action d'une force d'actionneur (40) agissant à l'encontre de la direction d'actionnement (12), dans lequel
la partie de fonctionnement (8) est couplée à la fois au capteur de force (19) et au système actionneur (23) par l'intermédiaire d'un élément de levier (30) pour transmettre la force de fonctionnement (12) et la force d'actionneur (40) et dans le cas présent, la partie de fonctionnement (8) est disposée sur un côté (43) de l'élément de levier (30) et le capteur de force (19) et le système actionneur (23) sont disposés sur un côté (44) faisant face de l'élément de levier (30) de sorte que l'élément de levier (30) est disposé entre la partie de fonctionnement (8) d'une part et le capteur de force (19) et le système actionneur (23) d'autre part, et le capteur de force (19) et le système actionneur (23) sont disposés sur des côtés (41, 42) différents d'un axe de rotation (31) de l'élément de levier (30), et dans lequel un élément de transmission (33) servant à transmettre la force de fonctionnement (12) de la partie de fonctionnement (8) vers l'élément de levier (30) est disposé par rapport à l'élément de levier (30) sur le même côté (42) de l'axe de rotation (31) que le capteur de force (19) et l'élément de transmission (33) transmet la force de fonctionnement (12) en tant que force de pression de la partie de fonctionnement (8) sur le capteur de force (19) par l'intermédiaire de l'élément de levier (30) et le système actionneur (23) réduit la force de fonctionnement (12) agissant sur le capteur de force (19) en exerçant une force de traction.

2. Dispositif de fonctionnement (3) selon la revendication 1, dans lequel parmi des espacements (36, 37, 38) respectifs de zones de contact (35) respectives de l'élément de transmission (33), du capteur de force (19) et du système actionneur (23) d'une part avec l'élément de levier (30) d'autre part par rapport à l'axe de rotation (31), l'espacement (38) de la zone de contact (35) de l'élément de transmission (33) est le plus grand.

3. Dispositif de fonctionnement (3) selon l'une quelconque des revendications précédentes, dans lequel le système actionneur (23) présente une bobine électrique (24), laquelle génère en fonction du signal d'activation (24) une force magnétique (45), dans lequel a) la bobine (26) présente un élément d'ancrage (28) monté de manière mobile, présentant un matériau ferromagnétique et couplé à l'élément de levier (30) et/ou b) l'élément de levier (30) présente un matériau ferromagnétique, dans lequel dans le cas d'un électroaimant (25) activé, la force magnétique (45) de la bobine électrique (26) agit sur le matériau respectif ferromagnétique.

4. Dispositif de fonctionnement (3) selon l'une quelconque des revendications précédentes, dans lequel un système de rappel (46) est mis au point de telle manière qu'il soumet la partie de fonctionnement (8) à l'action d'une force de rappel (47) agissant en direction de la position de repos (S).

5. Dispositif de fonctionnement (3) selon l'une quelconque des revendications précédentes, dans lequel est transmise la force d'actionneur (40) par l'élément de levier (30) sur la partie de fonctionnement (8) par un premier rapport de levier, qui est différent d'un rapport de levier, par lequel la force de fonctionnement (12) est transmise par l'élément de levier (30) de la partie de fonctionnement (12) au capteur de force (19).

6. Dispositif de fonctionnement (3) selon l'une quelconque des revendications précédentes, dans lequel un système de commande (21) est fourni et est mis au point de telle manière qu'il génère le signal d'activation (24) en fonction du signal de force (20).

7. Véhicule automobile (1) avec au moins un appareil (2) et avec un dispositif de fonctionnement (3) selon l'une quelconque des revendications précédentes, dans lequel le dispositif de fonctionnement (3) est couplé à l'au moins un appareil (2) et est configuré pour générer, en fonction d'un signal de force (20) d'un capteur de force (19) du dispositif de fonctionnement (3), un signal de commande (4) et l'envoyer à l'au moins un appareil (2).
